# EUROPEAN PATENT APPLICATION

(11) **EP 4 002 692 A1**
(43) Date of publication of application: **25.05.2022**
(21) Application number: 20206953.0
(22) Date of filing: 11.11.2020
(51) Int. Cl.: H03K 17/06, H03K 17/16, H03K 19/018

(54) **COMMUNICATION CIRCUIT AND METHOD OF TRANSFERRING A DATA SIGNAL**

(71) Applicant: Aptiv Technologies Limited, St. Michael (BB)
(72) Inventor: TYPROWICZ, Wojciech, Dublin, 2 (IE)
(74) Representative: Gaunt, Thomas Derrick

(57) **Abstract**

Communication circuit (1) including a transmitter module (2) including a first bipolar junction transistor (10) having a base (11) connected to an input (7) for receiving a data signal. A receiver module (3) is provided including a second bipolar junction transistor (20) having a collector (22) connected to an output (8) for outputting the data signal. A data line (9) connects between a collector (12) of the first bipolar junction transistor (10) and a base (21) of the second bipolar junction transistor (20) for transferring the data signal from the input (7) of the transmitter module (2) to the output (8) of the receiver module (3). One of the first and second bipolar junction transistors (10,20) is an NPN bipolar junction transistor and the other of the first and second bipolar junction transistors (10,20) is a PNP bipolar junction transistor.

## Description

### Introduction

The present disclosure relates to a communication circuit and a method of transferring a data signal. In particular, the disclosure relates to a unidirectional communication apparatus for serial data transmissions.

### Background

Communication data lines are used to transmit data and signals between different circuit modules within a system. In instances where circuit modules are separated by longer distances, the different circuit modules will often have separate ground connections. However, voltage shifts between the different grounds can lead to ground loops and signal distortion. For instance, in a vehicle E/E architecture, wiper blade breaking may be controlled using a H-Bridge controller having a field effect transistor (FET) switched by a control signal. If the ground current for the FET rises by around 2V, and the load is switched off, the energy from the ground wire may cause a negative voltage kickback of around -20V. In this scenario, the logic state of the H-Bridge controller cannot be recognised, risking failure to operate correctly and potentially even damage to the H-Bridge controller itself. As a consequence, it is normally necessary to provide galvanic isolators between communicating circuit modules.

Galvanic isolators act to provide signal isolation by preventing the direct flow of current between the two communicating modules using components such as optocouplers or iCouplers. However, these components are relatively expensive, especially when the cost is considered in the context that the isolation only becomes necessary if the ground shifts by more than a few volts. This is a particular issue in automotive applications where a large number of communicating modules are distributed around the vehicle. Such modules are often associated with vehicle sensor systems, meaning that they are particularly sensitive to signal disturbances. At the same time, the component costs for implementing the required isolation for each sensor is significant, and only continues to increase as vehicle E/E architectures become more complex.

The present disclosure is therefore directed to addressing these issues.

### Summary

According to a first aspect there is provided a communication circuit having: a transmitter module including a first bipolar junction transistor having a base connected to an input for receiving a data signal; a receiver module including a second bipolar junction transistor having a collector connected to an output for outputting the data signal; a data line connecting between a collector of the first bipolar junction transistor and a base of the second bipolar junction transistor for transferring the data signal from the input of the transmitter module to the output of the receiver module, wherein one of the first and second bipolar junction transistors is a NPN bipolar junction transistor and the other of the first and second bipolar junction transistors is a PNP bipolar junction transistor.

In this way, data signals may be transmitted over the data line without disturbances which could otherwise arise from the transmitter and receiver having separate ground connections. As such, both the transmitter and receiver are protected, with the bipolar junction transistors (BJTs) being paired in an inverted configuration for transferring the data signal between the two sides of the circuit. At the same time, BJTs are significantly less expensive than galvanic isolator components, and the above arrangement facilitates fast data transfer rates through the rapid activation of the BJTs. Consequently, a fast and inexpensive communication circuit may be provided, which is not sensitive to voltage differences between separate ground connections.

In embodiments, the first bipolar junction transistor is the NPN bipolar junction transistor.

In embodiments, the first bipolar junction transistor is in a common-emitter configuration.

In embodiments, the second bipolar junction transistor is in a common-emitter configuration.

In embodiments, at least one of the transmitter and receiver modules includes an emitter resistor.

In embodiments, at least one of the transmitter and receiver modules includes a collector resistor.

In embodiments, at least one of the transmitter and receiver modules includes an emitter resistor and a collector resistor, and wherein the resistances of the emitter resistor and collector resistor are selected for changing the voltage level of the data signal at the output relative to the voltage level of the data signal at the input. In this way, the signal voltage level may be translated from the input to the output. For instance, the resistors may be configured for increasing the voltage gain so that the high voltage periods of the output signal have a higher voltage than the high voltage periods of the input signal.

In embodiments, the transmitter module includes a base resistor.

In embodiments, the receiver module includes an output resistor.

In embodiments, the transmitter module and the receiver module have separate ground connections.

In embodiments, the transmitter module and the receiver module have a common positive supply rail.

In embodiments, at least one of the transmitter and receiver modules is configured for biasing the respective one of the first and second bipolar junction transistors for operating in the active region. In this way, the BJTs may provide a rapid response by avoiding saturation. This may thereby allow for fast data transfer rates of, for example, more than 10 Mbps.

According to a second aspect, there is provided a method of transferring a data signal, the method including: receiving a data signal at an input of a transmitter module comprising a first bipolar junction transistor, where the input is connected to a base of the first bipolar junction transistor for activating the first bipolar junction transistor in response to the data signal; providing a receiver module including a second bipolar junction transistor; connecting the collector of the first bipolar junction transistor to a base of a second bipolar junction transistor via a data line for activating the second bipolar junction transistor in response to activation of the first bipolar junction transistor; connecting a collector of the second bipolar junction transistor to an output for outputting the data signal in response to activation of the second bipolar junction transistor, wherein one of the first and second bipolar junction transistors is a NPN bipolar junction transistor and the other of the first and second bipolar junction transistors is a PNP bipolar junction transistor.

In embodiments, the data signal includes high voltage periods and low voltage periods. In this way, a digital signal may be transmitted over the data line, thereby allowing communication between separated integrated circuits and microcontrollers.

In embodiments, the method further includes selecting the resistances of an emitter resistor and a collector resistor provided in at least one of the transmitter and receiver modules for changing the voltage level of the data signal at the output relative to the voltage level of the data signal at the input.

In embodiments, the method further includes configuring at least one of the transmitter and receiver modules biasing the respective one of the first and second bipolar junction transistors for operating in the active region. In this way, the BJTs may provide a rapid response by avoiding saturation.

### Brief Description of Drawing

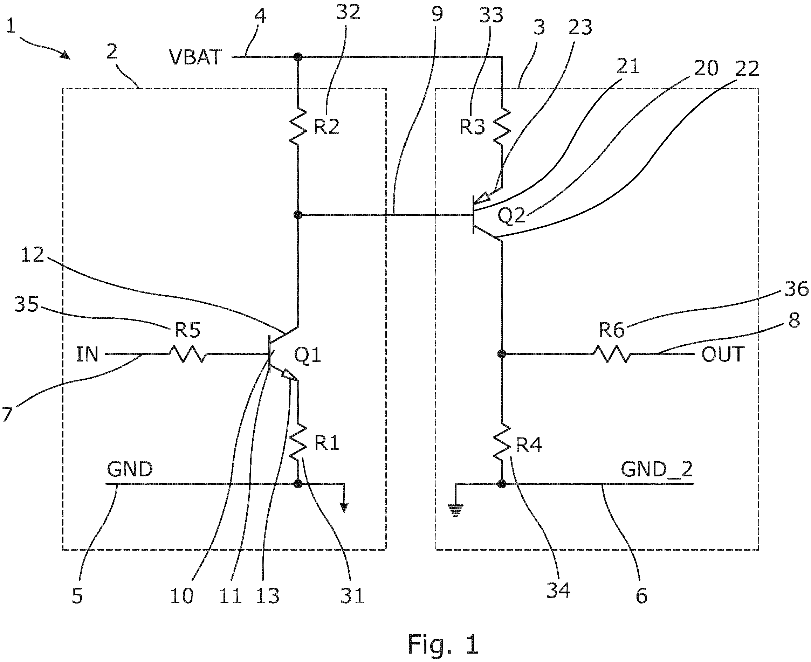

An illustrative embodiment will now be described with reference to the accompanying drawing in which Figure 1 shows a schematic communication circuit.

### Detailed Description

Figure 1 shows an illustrative embodiment of a communication circuit 1. The circuit includes a transmitter module 2 and receiver module 3 which are communicatively connected by data line 9 and share a common positive rail (VBAT) 4 from the battery. The transmitter and receiver modules 2,3 have separate connections to ground, with the transmitter module 2 being connected to a first ground line (GND) 5, and the receiver module 3 being connected to a second ground line (GND_2) 6.

The transmitter module 2 includes a NPN bipolar junction transistor (BJT Q1) 10 having a base 11, a emitter 13 and a collector 12. The base 11 is connected to an input 7 for receiving a data signal. An input resistor (R5) 35 is provided in the input line for regulating in the input current. BJT Q1 10 is provided in a common emitter configuration, with the emitter 13 connected to GND 5 through emitter resistor (R1) 31, and the collector 12 connected to the data line 9 as an output and VBAT 4 through collector resistor (R2) 32. The selected resistance of resistors R1 31 and R2 32 allows the voltage gain output from the collector 12 through the data line 9 to be adjusted by varying the ratio of the resistors. R1 31 and R2 32 also function to increase the linearity and stability of the operation of BJT Q1 10.

The receiver module 3 includes a PNP bipolar junction transistor 20 having a base 21, an emitter 23 and a collector 22. The base 21 is connected to the data line 9 for receiving the output from the collector 12 of BJT Q1 10. An output resistor (R6) 36 is provided in the output line for regulating the output current. BJT Q2 20 is provided in a common emitter configuration, with the emitter 23 connected to VBAT 4 through emitter resistor (R3) 33, and the collector 22 providing the output and connected to GND 2 6 through collector resistor (R4) 34. The selected resistance of resistors R3 33 and R4 34 allows the voltage gain output from the collector 22 through the output line 8 to be adjusted by varying the ratio of the resistors. R3 33 and R4 34 also function to increase the linearity and stability of the operation of BJT Q2 20.

In use, a data signal is applied to the input line 7. The data signal includes a sequence of high signal periods having a relatively high voltage level and low signal periods having a relatively low voltage level. Depending on the protocol, each period may represent a bit of data. When a high signal is applied to the base 11 it activates BJT Q1 10, which in turn generates a low signal in the data line 9 as current flows to GND 5. The low signal in data line 9 is applied to the base 21 of BJT Q2 20, which as a PNP transistor activates, generating a high signal in the output line 8 corresponding to the high signal at the input line 7. Conversely, when a low signal is applied to the base 11, BJT Q1 10 is off, which results in a high signal in the data line 9. This high signal in the data line 9 is applied to the base 21 of BJT Q2 20, which turns this PNP transistor off, thereby generating a low signal in the output line 8 corresponding to the low signal at the input line 7.

In this way, the communication circuit 1 may provide for the fast transmission of digital signals between the transmitter 2 and receiver 3 over the data line 9, without disturbances that could arise from voltage shifts between GND 5 and GND_2 6. That is, the use of BJTs, which are current controlled devices, rather than voltage-controlled FETs, means that the circuit is not sensitive to voltage difference between GND 5 and GND_2 6. Indeed, differences almost as high as VBAT may be tolerated. As such, both modules are protected.

Furthermore, the BJTs and resistor values may be selected so that BJT Q1 10 and BJT Q2 20 operate in the active region. Accordingly, by avoiding saturation of the transistor in this way, fast data transfer rates of more than 10 Mbps may be achieved. This is because the transistors may operate within their respective linear regions, which improves the speed of transition between high and low signals. This may thereby allow the communication circuit to be used for a wide variety of serial communication protocols.

Moreover, as the voltage gain outputs from collector 12 of the BJT Q1 10 and collector 22 of BJT Q2 20 can be varied based on the respective resistor selections, the communication circuit may provide a voltage level shift in the data signal between the input 7 and the output 8. For example, a serial data signal with a high signal at 3.3V may be translated to a high signal at 5V.

It will be understood that the embodiment illustrated above show applications only for the purposes of illustration. In practice, embodiments may be applied to many different configurations, the detail of which being straightforward for those skilled in the art to implement.

## Claims

**1.** A communication circuit comprising:
a transmitter module comprising a first bipolar junction transistor having a base connected to an input for receiving a data signal;
a receiver module comprising a second bipolar junction transistor having a collector connected to an output for outputting the data signal;
a data line connecting between a collector of the first bipolar junction transistor and a base of the second bipolar junction transistor for transferring the data signal from the input of the transmitter module to the output of the receiver module,
wherein one of the first and second bipolar junction transistors is a NPN bipolar junction transistor and the other of the first and second bipolar junction transistors is a PNP bipolar junction transistor.

**2.** A communication circuit according to claim 1, wherein the first bipolar junction transistor is the NPN bipolar junction transistor.

**3.** A communication circuit according to claim 1 or 2, wherein the first bipolar junction transistor is in a common-emitter configuration.

**4.** A communication circuit according to any preceding claim, wherein the second bipolar junction transistor is in a common-emitter configuration.

**5.** A communication circuit according to any preceding claim, wherein at least one of the transmitter and receiver modules comprises an emitter resistor.

**6.** A communication circuit according to any preceding claim, wherein at least one of the transmitter and receiver modules comprises a collector resistor.

**7.** A communication circuit according to claim 6 when dependent on claim 5, wherein at least one of the transmitter and receiver modules comprises an emitter resistor and a collector resistor, and wherein the resistances of the emitter resistor and collector resistor are selected for changing the voltage level of the data signal at the output relative to the voltage level of the data signal at the input.

**8.** A communication circuit according to any preceding claim, wherein the transmitter module comprises a base resistor.

**8.** A communication circuit according to any preceding claim, wherein the receiver module comprises an output resistor.

**9.** A communication circuit according to any preceding claim, wherein the transmitter module and the receiver module have separate ground connections.

**10.** A communication circuit according to any preceding claim, wherein the transmitter module and the receiver module have a common positive supply rail.

**11.** A communication circuit according to any preceding claim, wherein at least one of the transmitter and receiver modules is configured for biasing the respective one of the first and second bipolar junction transistors for operating in the active region.

**12.** A method of transferring a data signal, the method comprising:
receiving a data signal at an input of a transmitter module comprising a first bipolar junction transistor, where the input is connected to a base of the first bipolar junction transistor for activating the first bipolar junction transistor in response to the data signal;
providing a receiver module comprising a second bipolar junction transistor;
connecting the collector of the first bipolar junction transistor to a base of a second bipolar junction transistor via a data line for activating the second bipolar junction transistor in response to activation of the first bipolar junction transistor;
connecting a collector of the second bipolar junction transistor to an output for outputting the data signal in response to activation of the second bipolar junction transistor,
wherein one of the first and second bipolar junction transistors is a NPN bipolar junction transistor and the other of the first and second bipolar junction transistors is a PNP bipolar junction transistor.

**13.** A method according to claim 12, wherein the data signal comprises high voltage periods and low voltage periods.

**14.** A method according to any one of claims 12 or 13, further comprising selecting the resistances of an emitter resistor and a collector resistor provided in at least one of the transmitter and receiver modules for changing the voltage level of the data signal at the output relative to the voltage level of the data signal at the input.

**15.** A method according to any one of claims 12-14, further comprising configuring at least one of the transmitter and receiver modules biasing the respective one of the first and second bipolar junction transistors for operating in the active region.
